# EUROPEAN PATENT SPECIFICATION

(11) **EP 4 357 402 B1**
(45) Date of publication and mention of the grant of the patent: **06.08.2025**
(21) Application number: 23807882.8
(22) Date of filing: 16.05.2023
(51) Int. Cl.: C08K 5/5415, C08K 5/14, C08K 5/5419, C08J 5/18, H10F 19/80

(54) **ENCAPSULATION FILM COMPOSITION AND ENCAPSULATION FILM COMPRISING SAME**
VERKAPSELUNGSFOLIENZUSAMMENSETZUNG UND VERKAPSELUNGSFOLIE DAMIT
COMPOSITION DE FILM D'ENCAPSULATION ET FILM D'ENCAPSULATION LA COMPRENANT

(30) Priority: 16.05.2022 KR 20220059611
(43) Date of publication of application: 24.04.2024
(73) Proprietor: LG Chem, Ltd., Seoul 07336 (KR)
(72) Inventor: GONG, Jin Sam, Daejeon 34122 (KR); LEE, Eun Jung, Daejeon 34122 (KR); PARK, Sang Eun, Daejeon 34122 (KR); LEE, Si Jung, Daejeon 34122 (KR); KIM, Jong Gil, Daejeon 34122 (KR)
(74) Representative: Hoffmann Eitle
(86) International application number: PCT/KR2023/006625
(87) International publication number: WO 2023/224363

(56) References cited:
- WO-A1-2023/075364
- CN-A- 114 094 102
- JP-A- 2009 173 773
- KR-A- 20140 117 489
- KR-A- 20200 070 326
- KR-A- 20210 014 579

## Description

### TECHNICAL FIELD

### Cross-reference to Related Applications

This application claims the benefit of Korean Patent Application No. 10-2022-0059611, filed on May 16, 2022, in the Korean Intellectual Property Office.

### Technical Field

The present invention relates to an encapsulant film composition, an encapsulant film, and a solar cell module, the composition including an ethylene/alpha-olefin copolymer.

### BACKGROUND ART

As global environmental problems, energy problems, etc. are getting worse and worse, solar cells are attracting attention as a means of generating energy without environmental pollution and depletion. When solar cells are used outdoors, such as the roof of a building, a module type thereof is generally used. In order to obtain a crystalline solar cell module when a solar cell module is produced, front glass/solar cell encapsulant/crystalline solar cell element/solar cell encapsulant/back glass (or back protective sheet) are stacked in this order. As the solar cell encapsulant, an ethylene/vinyl acetate copolymer or ethylene/alpha-olefin copolymer having excellent transparency, flexibility, adhesion, or the like is generally used.

The solar cell module is packaged by protecting a solar cell element including such materials such as silicon, gallium-arsenic, and copper-indium-selenium with a top transparent protective material and a bottom substrate protective material, and fixing the solar cell element and the protective material with an encapsulant. Generally, the encapsulant of the solar cell element in the solar cell module is produced by extruding a sheet from an ethylene/alpha-olefin copolymer in which an organic peroxide or a silane coupling agent has been mixed, and the encapsulant in the form of sheet thus obtained is used to encapsulate the solar cell element to produce a solar cell module.

When the solar cell module as described above is produced, in order to improve productivity, one method may be to increase the affinity between the ethylene/alpha-olefin copolymer and various raw materials included in the encapsulant film composition, thereby increasing absorbency. In particular, a crosslinking agent, a crosslinking aid, and the like, which are essentially used for producing an encapsulant film, are polar substances and thus have a low absorbency for a non-polar ethylene/alpha-olefin copolymer, which is pointed out as one of the factors that cause a decrease in the productivity.

### [Prior Art Document]

### [PATENT DOCUMENT]

(Patent Document 1) Japanese Laid-open Patent No. 2015-211189
(Patent Document 2) Korean Patent Publication No. KR20200070326A

### DISCLOSURE OF THE INVENTION

### TECHNICAL PROBLEM

The purpose of the present invention is to reduce the impregnation time of an ethylene/alpha-olefin copolymer at an initial stage during the production of an encapsulant film by using a crosslinking agent, a crosslinking aid, and the like having high compatibility with the ethylene/alpha-olefin copolymer.

### TECHNICAL SOLUTION

In order to solve the above problem, the present invention provides an encapsulant film composition, an encapsulant film, and a solar cell module.
(1) According to an aspect of the present invention, there is provided an encapsulant film composition including an ethylene/alpha-olefin copolymer, a crosslinking agent, a crosslinking aid, and a silane coupling agent, wherein the crosslinking aid includes a compound represented by Formula 1 below: 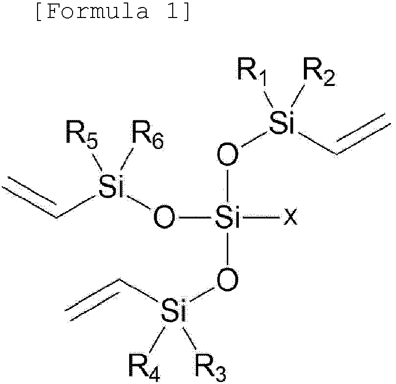
   In Formula 1 above,
   R₁ to R₆ are each independently an alkyl group having 1 to 10 carbon atoms, and
   X is an aryl group having 6 to 30 carbon atoms or 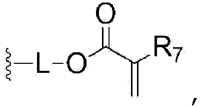 where L is an alkylene group having 1 to 10 carbon atoms, and R₇ is an alkyl group having 1 to 10 carbon atoms.
(2) In (1) above of the present invention, there is provided the encapsulant film composition, wherein in Formula 1 above, R₁ to R₆ are each independently an alkyl group having 1 to 6 carbon atoms.

In (1) or (2) above of the present invention, there is provided the encapsulant film composition, wherein the compound represented by Formula 1 above is selected from among compounds below:

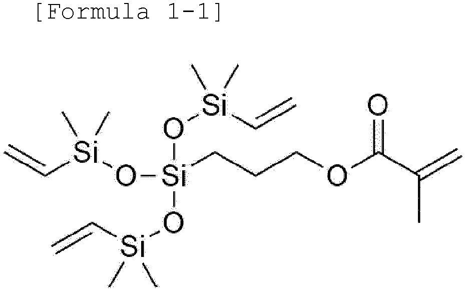

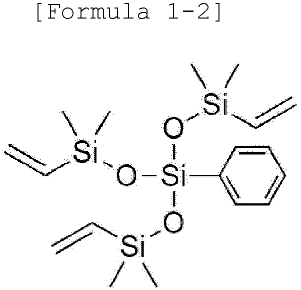

(4) In any one of (1) to (3) above of the present invention, there is provided the encapsulant film composition, wherein the crosslinking aid is contained in an amount of 0.01 parts by weight to 1 part by weight based on 100 parts by weight of the encapsulant film composition.

(5) In any one of (1) to (4) above of the present invention, there is provided the encapsulant film composition further including an allyl group-containing compound as the crosslinking aid, wherein the allyl group-containing compound includes at least one selected from the group consisting of triallyl isocyanurate, triallyl cyanurate, diallyl phthalate, diallyl fumarate, and diallyl maleate.

(6) In (5) above of the present invention, there is provided the encapsulant film composition, wherein the molar ratio of the compound represented by Formula 1 above and the allyl group-containing compound is 1:0.1 to 1:10.

(7) In any one of (1) to (6) above of the present invention, there is provided the encapsulant film composition, wherein the alpha-olefin includes at least one selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

(8) In any one of (1) to (7) above of the present invention, there is provided the encapsulant film composition, wherein the alpha-olefin is contained in an amount of greater than 0 and less than or equal to 99 mol%, based on the ethylene/alpha-olefin copolymer.

(9) In any one of (1) to (8) above of the present invention, there is provided the encapsulant film composition further including at least one selected from the group consisting of an unsaturated silane compound, an aminosilane compound, a light stabilizer, a UV absorber, and a thermal stabilizer.

(10) According to another aspect of the present invention, there is provided an encapsulant film including the encapsulant film composition of any one of (1) to (9).

(11) According to still another aspect of the present invention, there is provided a solar cell module including the encapsulant film of (10) above.

### ADVANTAGEOUS EFFECTS

When an encapsulant film is produced using the encapsulant film composition according to the present invention, the immersing time of an ethylene/alpha-olefin copolymer is reduced so that the economic viability of a process of producing an encapsulant film can be improved. In addition, the encapsulant film composition produced by using the present invention exhibits excellent crosslinking degree.

### MODE FOR CARRYING OUT THE INVENTION

Hereinafter, the present invention will be described in more detail to aid in understanding the present invention.

### <Encapsulant Film Composition>

An encapsulant film composition of the present invention includes (a) an ethylene/alpha-olefin copolymer, (b) a crosslinking agent, (c) a crosslinking aid, and (d) a silane coupling agent, wherein the crosslinking aid includes a compound represented by Formula 1.

Hereinafter, each component will be described in detail.

### (a) Ethylene/alpha-olefin copolymer

The encapsulant film composition of the present invention includes an ethylene/alpha-olefin copolymer. The ethylene/alpha-olefin copolymer is prepared by copolymerizing ethylene and an alpha-olefin-based monomer, in which the alpha-olefin, which refers to a portion derived from the alpha-olefin-based monomer in the copolymer, may include alpha-olefin having 4 to 20 carbon atoms, specifically, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, or the like, and may be one alone or a mixture of two or more thereof.

Among these, the alpha-olefin may be 1-butene, 1-hexene, or 1-octene, and preferably may be 1-butene, 1-hexene, or a combination thereof.

In addition, the content of the alpha-olefin in the ethylene/alpha-olefin copolymer may be appropriately selected within a range satisfying the above-described physical properties, and specifically, may be greater than 0 and less than or equal to 99 mol%, and 10-50 mol%, but is not limited thereto.

In the present invention, a method for preparing an ethylene/alpha-olefin copolymer or an obtaining route thereof is not limited, and a person skilled in the art may select and use an appropriate one in consideration of the physical properties and purpose of an encapsulant film composition.

### (b) Crosslinking agent

The encapsulant film composition of the present invention includes a crosslinking agent. The crosslinking agent is a radical initiator in the preparation step of the silane modified resin composition and may play the role of initiating the grafting reaction of the unsaturated silane compound into the resin composition. In addition, by forming a crosslinking bond in the silane modified resin composition or between the silane modified resin composition and an unmodified resin composition in the step of lamination during manufacturing an optoelectronic device, the heat resistance and durability of a final product, for example, an encapsulant sheet may be improved.

The crosslinking agent may use various crosslinking agents known in the art as long as it may be a crosslinking agent which may initiate the radical polymerization of a vinyl group or form a crosslinking bond, for example, one or two or more selected from the group consisting of an organic peroxide, a hydroperoxide and an azo compound may be used.

For example, the encapsulant for a solar cell may include organic peroxide as a crosslinking agent, and the organic peroxide serves to improve weather resistance of the encapsulant for a solar cell.

In particular, one or more selected from the group consisting of: dialkyl peroxides such as *t*-butylcumylperoxide, di-*t*-butyl peroxide, di-cumyl peroxide, 2,5-dimethyl-2,5-di(*t-*butylperoxy) hexane, and 2,5-dimethyl-2,5-di(*t*-butylperoxy)-3-hexyne; hydro peroxides such as cumene hydroperoxide, diisopropyl benzene hydro peroxide, 2,5-dimethyl-2,5-di(hydroperoxy)hexane, and t-butylhydroperoxide; diacyl peroxides such as bis-3,5,5-trimethylhexanoyl peroxide, octanoylperoxide, benzoyl peroxide, *o*-methylbenzoylperoxide, and 2,4-dichlorobenzoyl peroxide; peroxy esters such as *t-*butylperoxy iso butyrate, *t*-butylperoxy acetate, *t-*butylperoxy-2-ethylhexylcarbonate (TBEC), *t*-butylperoxy-2-ethylhexanoate, t-butylperoxy pivalate, *t*-butylperoxy octoate, *t*-butylperoxyisopropyl carbonate, *t*-butylperoxybenzoate, di*t*-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide, and cyclohexanone peroxide, and azo compounds such as lauryl peroxide, azobisisobutyronitrile and azobis(2,4-dimethylvaleronitrile), may be included, but are not limited thereto.

The organic peroxide may be an organic peroxide having a one-hour half-life temperature of 120 °C to 135 °C, for example, 120 °C to 130 °C, 120 °C to 125 °C, preferably, 121 °C. The "one-hour half-life temperature" means a temperature at which the half-life of the crosslinking agent becomes one hour. According to the one-hour half-life temperature, the temperature at which the radical initiation reaction is efficiently carried out is changed, and accordingly, if an organic peroxide having the one-hour half-life temperature in the above-described range is used as the crosslinking agent, radical initiation reaction, that is, crosslinking reaction may be effectively performed at a lamination process temperature for manufacturing an optoelectronic device.

The crosslinking agent may be contained in an amount of 0.01-2 parts by weight, for example, 0.05-1.5 parts by weight, 0.1-1.5 parts by weight, or 0.5-1.5 parts by weight, based on 100 parts by weight of the ethylene/alpha-olefin copolymer. When the crosslinking agent is contained in the above range, an effect of improving heat resistance is sufficiently exhibited, and the moldability of the encapsulant film is also excellent, and thus a process restriction or a decrease in the physical properties of the encapsulant may not occur.

### (c) Crosslinking aid

The encapsulant film composition of the present invention includes a crosslinking aid, wherein the crosslinking aid includes a compound represented by Formula 1 below:

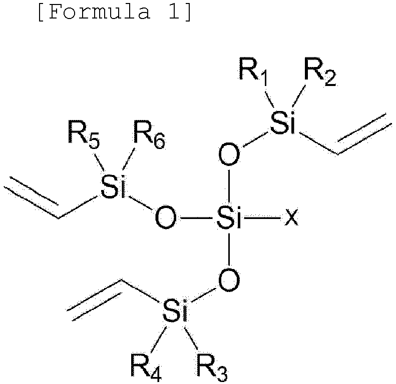

In Formula 1 above,
R₁ to R₆ are each independently an alkyl group having 1 to 10 carbon atoms, and
X is an aryl group having 6 to 30 carbon atoms or 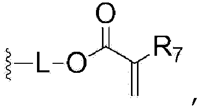 wherein L is an alkylene group having 1 to 10 carbon atoms, and R₇ is an alkyl group having 1 to 10 carbon atoms.

In Formula 1 above, R₁ to R₆ may be each independently an alkyl group having 1 to 6 carbon atoms, or an alkyl group having 1 to 3 carbon atoms, for example, a methyl group, an ethyl group, or a propyl group.

In Formula 1 above, X may be an aryl group having 6 to 30 carbon atoms, an aryl group having 6 to 10 carbon atoms, for example, a phenyl, or X may be 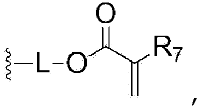 wherein L may be an alkylene group having 1 to 10 carbon atoms, an alkylene group having 1 to 6 carbon atoms, for example, a propylene group, and R₇ may be an alkyl group having 1 to 10 carbon atoms, an alkyl group having 1 to 6 carbon atoms, an alkyl group having 1 to 3 carbon atoms, for example, a methyl group.

More specifically, the compound represented by Formula 1 may be selected from among compounds below:

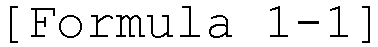

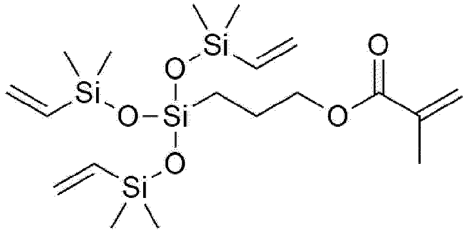

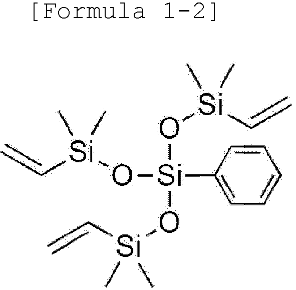

The crosslinking aid used in the present invention has excellent compatibility of the ethylene/alpha-olefin copolymer due to having higher hydrophobicity and lower liquid viscosity compared to triallyl isocyanurate (TAIC), which has been conventionally used, and thus may improve the impregnation rate of the ethylene/alpha-olefin copolymer in the encapsulant film composition.

In addition, when the double bond capable of crosslinking reaction is included in X above, crosslinking sites may be increased to increase the crosslinking degree, and the siloxane bond (Si-O-Si) of the crosslinking aid may be flexible to facilitate crosslinking reaction and have a high molecular weight, thereby exhibiting excellent crosslinking properties during the crosslinking.

By including the crosslinking aid in the encapsulant film composition, the crosslinking degree of the encapsulant film composition by the above-described crosslinking agent may be increased, and accordingly, the heat resistance and durability of a final product, for example, an encapsulant film may be even further improved.

The crosslinking aid may be 0.01 parts by weight to 1 part by weight, specifically, at least 0.05 parts by weight, at least 0.1 parts by weight, at least 0.2 parts by weight, at least 0.3 parts by weight, at most 1.0 parts by weight, and at most 0.8 parts by weight based on 100 parts by weight of the ethylene/alpha-olefin copolymer.

Within the above range, effects of improving heat resistance characteristics and the impregnation rate of the ethylene/alpha-olefin copolymer through the crosslinking aid may be sufficiently achieved, and a decrease in physical properties of the encapsulant film may be suppressed.

In the present invention, the encapsulant film composition may further include an allyl group-containing compound as the crosslinking aid, wherein the allyl group-containing compound includes at least one selected from the group consisting of triallyl isocyanurate, triallyl cyanurate, diallyl phthalate, diallyl fumarate, and diallyl maleate.

Here, the molar ratio of the compound represented by Formula 1 above and the allyl group-containing compound may be 1:0.1 to 1:10, specifically, 1:2 to 1:5, and more specifically 1:0.3 to 1:3, or 1:0.3 to 1:0.8.

Within the above range, the crosslinking degree of the encapsulant film composition may also be improved while reducing the impregnation time of the ethylene/alpha-olefin copolymer.

### (d) Silane coupling agent

The encapsulant film composition of the present invention includes a silane coupling agent, which may serve to improve the adhesion between the encapsulant film and the solar cell.

As the silane coupling agent, for example, one or more selected from the group consisting of *N*-(β-aminoethyl)-γ-aminopropyltrimethoxysilane, *N*-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO) may be used, but the present invention is not limited thereto.

The silane coupling agent may be contained in an amount of 0.1-0.4 parts by weight based on 100 parts by weight of the encapsulant film composition. When the content of the silane coupling agent is within the above range, the solar cell module may have excellent adhesion to the glass, thereby preventing deterioration of long-term performance of the module due to the penetration of moisture.

In addition, the encapsulant film composition of the present invention may further include at least one selected from the group consisting of an unsaturated silane compound, an aminosilane compound, a light stabilizer, a UV absorber, and a thermal stabilizer.

The unsaturated silane compound may be grafted into a main chain including a polymerization unit of the monomer of the copolymer of the present invention in the presence of a radical initiator to be included in a polymerized state into a silane modified resin composition or an amino silane modified resin composition.

The unsaturated silane compound may be vinyltrimethoxy silane, vinyltriethoxy silane, vinyltripropoxy silane, vinyltriisopropoxy silane, vinyltributoxy silane, vinyltripentoxy silane, vinyltriphenoxy silane, vinyltriacetoxy silane, or the like, and in an embodiment, the vinyltrimethoxy silane or the vinyltriethoxy silane may be used among them, without limitation.

In addition, the amino silane compound may further improve the adhesive strength with the back side sheet composed of top and bottom glass substrates or a fluorine resin, by acting as a catalyst promoting hydrolysis reaction transforming a reactive functional group such as an alkoxy group of an unsaturated silane compound, for example, vinyltriethoxy silane, which is grafted into the copolymer, into a hydroxyl group in the grafting modification step of an ethylene/alpha-olefin copolymer. At the same time, the amino silane compound participates directly in a copolymerization reaction as a reactant, and a moiety having an amine functional group in an amino silane modified resin composition may be provided.

The amino silane compound may be any silane compounds including an amine group as long as it is a primary amine and a secondary amine, without specific limitation. For example, as the amino silane compound, aminotrialkoxysilane, aminodialkoxysilane, etc., may be used, and the example thereof may include one or more selected from the group consisting of 3-aminopropyltrimethoxysilane (APTMS), 3-aminopropyltriethoxysilane (APTES), bis[(3-triethoxysilyl)propyl]amine, bis[(3-trimethoxysilyl)propyl]amine, 3-aminopropylmethyldiethoxysilane, 3-aminopropylmethyldimethoxysilane, *N*-[3-(trimethoxysilyl)propyllethylenediamine (DAS), aminoethylaminopropyltriethoxysilane, aminoethylaminopropylmethyldimethoxysilane, aminoethylaminopropylmethyldiethoxysilane, aminoethylaminomethyltriethoxysilane, aminoethylaminomethylmethyldiethoxysilane, diethylenetriaminopropyltrimethoxysilane, diethylenetriaminopropyltriethoxysilane, diethylenetriaminopropylmethyldimethoxysilane, diethyleneaminomethylmethyldiethoxysilane, (*N-*phenylamino)methyltrimethoxysilane, (*N-*phenylamino)methyltriethoxysilane, (*N-*phenylamino)methylmethyldimethoxysilane, (*N-*phenylamino)methylmethyldiethoxysilane, 3-(*N-*phenylamino)propyltrimethoxysilane, 3-(*N-*phenylamino)propyltriethoxysilane, 3-(*N-*phenylamino)propylmethyldimethoxysilane, 3-(*N-*phenylamino)propylmethyldiethoxysilane, and *N*-(*N*-butyl)-3-aminopropyltrimethoxysilane. The amino silane compounds may be used alone or as a mixture type.

The light stabilizer may capture an active species for initiating the photo-induced degradation of a resin according to the use of the composition applied to play a role in preventing photooxidation. The kind of the light stabilizer used is not specifically limited, for example, known compounds such as a hindered amine-based compound and a hindered piperidine-based compound may be used.

The UV absorber, according to the use of the composition, absorbs ultraviolet rays from the sunlight, etc. and transform into harmless thermal energy in a molecule, and may play the role of preventing the excitation of the active species for initiating the photo-induced degradation in the resin composition. Particular kinds of the UV absorber used is not specifically limited, but, for example, benzophenone-based, benzotriazole-based, acrylonitrile-based, metal complex-based, hindered amine-based, inorganic UV absorber such as ultrafine titanium oxide particles and ultrafine zinc oxide particles may be used alone, or a mixture of two or more thereof may be used.

In addition, examples of the thermal stabilizer may include a phosphor-based thermal stabilizer such as tris(2,4-di-*tert*-butylphenyl)phosphite, bis[2,4-bis(1,1-dimethylethyl)-6-methylphenyl]ethylester phosphorous acid, tetrakis(2,4-di-*tert*-butylphenyl) [1,1-biphenyl]-4,4'-diylbisphosphonate and bis(2,4-di-*tert-*butylphenyl)pentaerythritoldiphosphite; and a lactone-based thermal stabilizer such as a reaction product of 8-hydroxy-5,7-di-*tert*-butyl-furan-2-on and o-xylene, and one or two or more thereof may be used.

The contents of the light stabilizer, UV absorber, and thermal stabilizer are not specifically limited. That is, the content of the additive may be appropriately selected considering the use of the resin composition, the shape or density of the additive, etc., and generally, may be appropriately controlled in a range of 0.01 parts by weight to 5 parts by weight based on 100 parts by weight of the total solid content of the encapsulant film composition.

### <Encapsulant Film and Solar Cell Module>

In addition, the present invention provides an encapsulant film including the encapsulant film composition.

The encapsulant film of the present invention may be produced by molding the encapsulant film composition into a film or a sheet shape. The molding method is not specifically limited, and may be produced by making a sheet or film through a common process, for example, a T die process or extrusion. For example, the production of the encapsulant film may be performed by an in situ process using an apparatus in which the preparation of a modified resin composition using the encapsulant film composition, and a process for making a film or a sheet are connected with each other.

The thickness of the encapsulant film may be controlled to about 10 µm to about 2,000 µm, or about 100 µm to about 1250 µm, considering the supporting efficiency and breaking possibility of a device in an optoelectronic device, the weight lightening or workability of the device, etc., and may be changed according to particular use.

In addition, the present invention provides a solar cell module including the encapsulant film. The solar cell module in the present invention may have a configuration in which gaps between solar cells disposed in series or in parallel are filled with the encapsulant film of the present invention, a glass surface is disposed on a surface hit by sunlight, and a rear surface is protected by a back sheet, but the present invention is not limited thereto, and various types and forms of solar cell modules manufactured by including the encapsulant film in the art may all be applied to the present invention.

The glass surface may be formed using tempered glass in order to protect the solar cell from external impact and prevent damage, and using low iron tempered glass having a low iron content in order to prevent the reflection of sunlight and increase transmittance of sunlight, but the present invention is not limited thereto.

The back sheet is a weather-resistant film for protecting the rear surface of the solar cell module from the outside, and includes, for example, a fluorine-based resin sheet, a metal plate or metal foil such as aluminum, a cyclic olefin-based resin sheet, a polycarbonate-based resin sheet, a poly(meth) acrylic-based resin sheet, a polyamide-based resin sheet, a polyester-based resin sheet, a composite sheet obtained by laminating a weather-resistant film and a barrier film, but is not limited thereto.

In addition, the solar cell module of the present invention may be manufactured according to a method known in the art, except including the above-described encapsulant film.

The solar cell module of the present invention is manufactured using the encapsulant film having excellent volume resistivity, and the encapsulant film may prevent a current from being leaked to the outside of the solar cell module due to the movement of electrons in the solar cell module, and thus a potential induced degradation (PID) phenomenon in which insulation is deteriorated, the current is leaked, and the output of the module is rapidly reduced may be significantly suppressed.

### Examples

Hereinafter, the present invention will be described in more detail according to the examples.

### Example 1

LF675 (ethylene/1-butene copolymer, density of 0.877 g/cc, MI of 14.0) made by LG chem, Ltd. was used as an ethylene/alpha-olefin copolymer.

The crosslinking agent impregnation was performed using Planetary Mixer made by Thermo Electron (Karlsruhe) GmbH. One phr (parts per hundred rubber) of *t*-butyl 1-(2-ethylhexyl)monoperoxycarbonate (TBEC), 0.5 phr of a compound represented by Formula 1-1 below (methacryloxypropyltris(vinyldimethylsiloxy)silane, MPVS), and 0.2 phr of methacryloxypropyltrimethoxysilane (MEMO) were added to 500 g of an ethylene/alpha-olefin copolymer, and then stirred at 40 rpm for 40 °C, and a change in the torque value over time was observed, and the impregnation was terminated when the torque value increased rapidly. Before the crosslinking agent is absorbed into the ethylene/alpha-olefin copolymer, the crosslinking agent acts as a lubricant to maintain a low torque value, and when all the crosslinking agents are absorbed, the torque value increases, so that the time point at which the torque value increases rapidly is set as the impregnation completion time.

Thereafter, an encapsulant film having an average thickness of 550 µm was prepared using a micro extruder at a low temperature (under conditions of an extruder barrel temperature of 100 °C or lower) to an extent that high-temperature crosslinking was not performed.

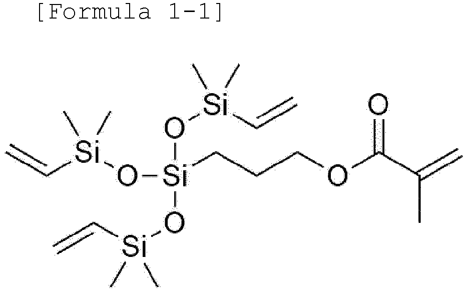

### Examples 2 to 6, and Comparative Examples 1 to 4

Encapsulant films were prepared in the same manner as in Example 1 except that the reaction conditions were changed as shown in Table 1 below.

**[Table 1]**

| | Crosslinking aid types | Weight ratio | Total amount of crosslinking aid (phr) |
|---|---|---|---|
| Example 1 | MPVS | - | 0.5 |
| Example 2 | MPVS | - | 0.25 |
| Example 3 | TVPS | - | 0.5 |
| Example 4 | MPVS+TAIC | 3:1 | 0.5 |
| Example 5 | MPVS+TAIC | 1:1 | 0.5 |
| Example 6 | MPVS+TAIC | 1:3 | 0.5 |
| Comparative Example 1 | TAIC | - | 0.5 |
| Comparative Example 2 | VTIPS | - | 0.5 |
| Comparative Example 3 | DVTMS | - | 0.5 |
| Comparative Example 4 | TVMS | - | 0.5 |

| | | | |
|---|---|---|---|
| *MPVS: Methacryloxypropyltris(vinyldimethylsiloxy)silane 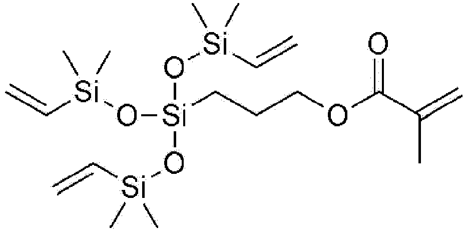 *TVPS: Tris(vinyldimethylsiloxy)phenylsilane 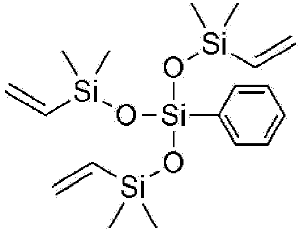 *TAIC: Triallyl isocyanurate 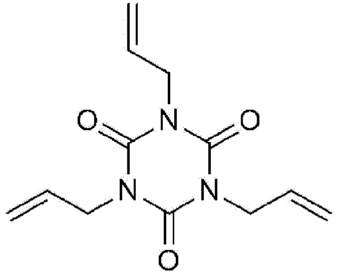 *VTIPS: Vinyl triisoprophenoxy silane 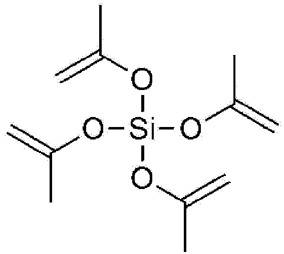 *DVTMS: Divinyl-1,1,3,3-tetramethyldisilazane 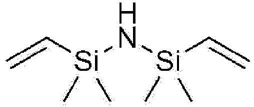 *TVMS: Tris(vinyldimethylsiloxy)methylsilane 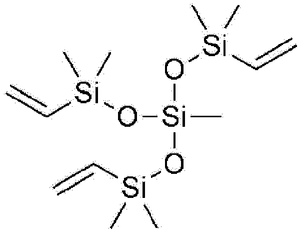 | | | |

### Experimental Example 1

The physical properties of the prepared-above encapsulant films of Examples and Comparative Examples were measured according to the following methods.

### (1) Impregnation rate (impregnation completion time)

As described above, the time point, at which the torque value increases rapidly, is set as the impregnation completion time, and the time from the time point at which the stirring is started to the time point at which the impregnation is completed is measured and shown in Table 2 below.

### (2) Crosslinking degree

The evaluation of crosslinking degree was performed based on the China Photovoltaic Industry Association (CPIA) standard and ASTM D2765. The encapsulant film prepared above was cut into 10 cm × 10 cm, and then vacuum lamination was performed at 150 °C for 20 minutes (vacuum 5 minutes/pressurizing 1 minute/pressure maintenance 14 minutes) to obtain a crosslinked specimen.

The crosslinked specimen was cut to a suitable size, then quantified to be 0.5 g each in a 200-mesh wire mesh cage, and dissolved under xylene reflux for 5 hours. Thereafter, after the specimens were dried in a vacuum oven, the crosslinking degree of each specimen was measured by comparing the weights before and after the reflux.

### (3) MDR torque (M_{H}-M_{L}, Nm)

For the evaluation of the degree of crosslinking, a moving die rheometer (MDR) torque value of each sample was measured using Alpha Technologies Production MDR.

Specifically, the encapsulant films (550 µm) prepared in Examples and Comparative Examples above were cut to be 1 g each and then overlapped with 4 sheets to prepare a sample having a total of 4 g, and then the sample was run and measured for 20 minutes at 150 °C. M_{H} and M_{L} values were measured under such conditions. MDR torque (M_{H}-M_{L}) was calculated by subtracting the M_{L} value from the measured M_{H} value. Here, M_{H} is a maximum vulcanizing torque, and M_{L} is a minimum vulcanizing torque.

**[Table 2]**

| | Impregnation completion time (min) | Crosslinking degree | M_{H}-M_{L} |
|---|---|---|---|
| Example 1 | 26 | 72 | 2.83 |
| Example 2 | 14 | 68 | 2.54 |
| Example 3 | 15 | 70 | 2.70 |
| Example 4 | 27 | 74 | 2.92 |
| Example 5 | 31 | 75 | 3.31 |
| Example 6 | 39 | 76 | 3.52 |
| Comparative Example 1 | 58 | 77 | 3.67 |
| Comparative Example 2 | 10 | 61 | 2.59 |
| Comparative Example 3 | 5 | 30 | 1.59 |
| Comparative Example 4 | 10 | 64 | 2.70 |

As shown in Table 2, in the case of Examples 1 to 6 using the encapsulant film composition of the present invention, the impregnation completion time was reduced due to the fast impregnation rate and the crosslinking degree was also exhibited to be excellent. On the other hand, it was confirmed that in the case of Comparative Example 1 using TAIC as the crosslinking aid, the impregnation completion time became far longer than those of Examples due to the slow impregnation rate, and in the case of Comparative Examples 2 to 4 using the compound not corresponding to Formula 1 as the crosslinking aid, the crosslinking degree was deteriorated.

As such, when the encapsulant film composition according to the present invention is used, there is an effect that an appropriate level of crosslinking degree is exhibited and the impregnation time is reduced.

## Claims

1. An encapsulant film composition comprising an ethylene/alpha-olefin copolymer, a crosslinking agent, a crosslinking aid, and an organic peroxide, wherein the crosslinking aid comprises a compound represented by Formula 1 below: 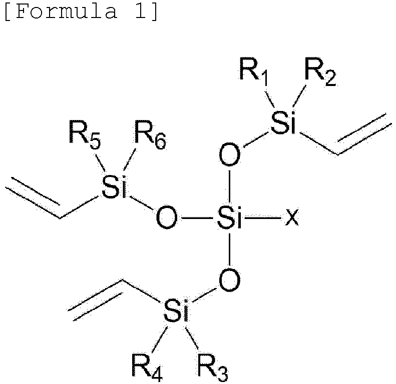 where, in Formula 1 above,
R₁ to R₆ are each independently an alkyl group having 1 to 10 carbon atoms, and
X is an aryl group having 6 to 30 carbon atoms or 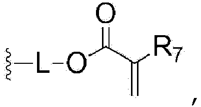
where L is an alkylene group having 1 to 10 carbon atoms, and R₇ is an alkyl group having 1 to 10 carbon atoms.

2. The encapsulant film composition of claim 1, wherein, in Formula 1 above, R₁ to R₆ are each independently an alkyl group having 1 to 6 carbon atoms.

3. The encapsulant film composition of claim 1, wherein the compound represented by Formula 1 above is selected from among compounds below:

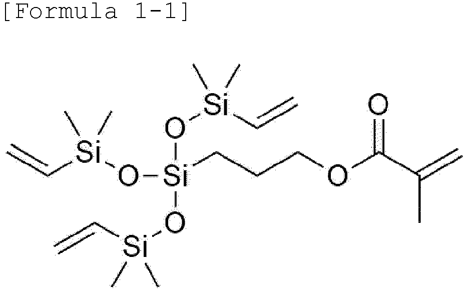

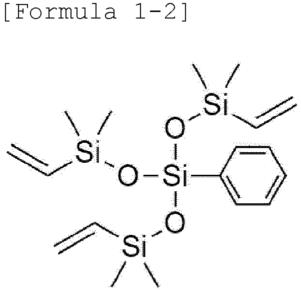

4. The encapsulant film composition of claim 1, wherein the crosslinking aid is contained in an amount of 0.01 parts by weight to 1 part by weight based on 100 parts by weight of the encapsulant film composition.

5. The encapsulant film composition of claim 1, further comprising an allyl group-containing compound as the crosslinking aid,
wherein the allyl group-containing compound comprises at least one selected from the group consisting of triallyl isocyanurate, triallyl cyanurate, diallyl phthalate, diallyl fumarate, and diallyl maleate.

6. The encapsulant film composition of claim 5, wherein the molar ratio of the compound represented by Formula 1 above and the allyl group-containing compound is 1:0.1 to 1:10.

7. The encapsulant film composition of claim 1, wherein the alpha-olefin comprises at least one selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

8. The encapsulant film composition of claim 1, wherein the alpha-olefin is contained in an amount of greater than 0 and less than or equal to 99 mol%, based on the ethylene/alpha-olefin copolymer.

9. The encapsulant film composition of claim 1, further comprising at least one selected from the group consisting of an unsaturated silane compound, an aminosilane compound, a light stabilizer, a UV absorber, and a thermal stabilizer.

10. An encapsulant film comprising the encapsulant film composition of any one of claims 1 to 9.

11. A solar cell module comprising the encapsulant film of claim 10.

## Patentansprüche

1. Einkapselungsfilmzusammensetzung, umfassend ein Ethylen/Alpha-Olefin-Copolymer, ein Vernetzungsmittel, einen Vernetzungs-Hilfsstoff und ein organisches Peroxid, worin der Vernetzungs-Hilfsstoff eine durch die nachstehende Formel 1 dargestellte Verbindung umfasst: 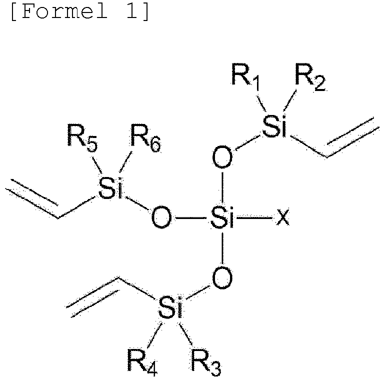 worin in der vorstehenden Formel 1
R₁ bis R₆ jeweils unabhängig eine Alkylgruppe mit 1 bis 10 Kohlenstoffatomen sind und
X eine Arylgruppe mit 6 bis 30 Kohlenstoffatomen oder 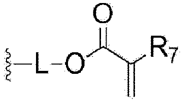
ist, worin L eine Alkylengruppe mit 1 bis 10 Kohlenstoffatomen ist und R₇ eine Alkylgruppe mit 1 bis 10 Kohlenstoffatomen ist.

2. Einkapselungsfilmzusammensetzung gemäß Anspruch 1, worin in der vorstehenden Formel 1 R₁ bis R₆ jeweils unabhängig eine Alkylgruppe mit 1 bis 6 Kohlenstoffatomen sind.

3. Einkapselungsfilmzusammensetzung gemäß Anspruch 1, worin die durch die vorstehende Formel 1 dargestellte Verbindung ausgewählt ist aus den nachstehenden Verbindungen:

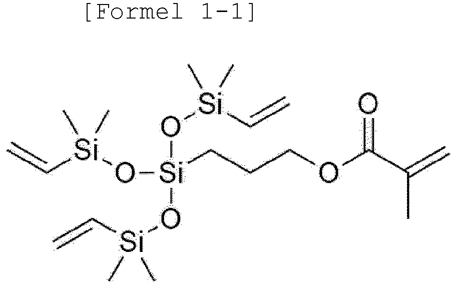

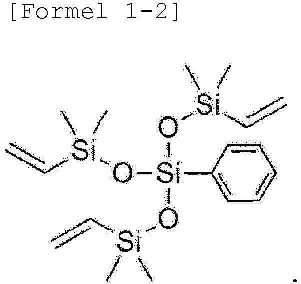

4. Einkapselungsfilmzusammensetzung gemäß Anspruch 1, worin der Vernetzungs-Hilfsstoff in einer Menge von 0,01 Gewichtsteilen bis 1 Gewichtsteil enthalten ist, bezogen auf 100 Gewichtsteile der Einkapselungsfilmzusammensetzung.

5. Einkapselungsfilmzusammensetzung gemäß Anspruch 1, ferner umfassend eine Allylgruppe-haltige Verbindung als Vernetzungs-Hilfsstoff,
worin die Allylgruppe-haltige Verbindung zumindest eines umfasst, ausgewählt aus der Gruppe bestehend aus Triallylisocyanurat, Triallylcyanurat, Diallylphthalat, Diallylfumarat und Diallylmaleat.

6. Einkapselungsfilmzusammensetzung gemäß Anspruch 5, worin das molare Verhältnis der durch die vorstehende Formel 1 dargestellte Verbindung zur Allylgruppe-haltigen Verbindung 1:0,1 bis 1:10 beträgt.

7. Einkapselungsfilmzusammensetzung gemäß Anspruch 1, worin das Alpha-Olefin zumindest eines umfasst, das ausgewählt ist aus der Grupp, bestehend aus Propylen, 1-Buten, 1-Penten, 4-Methyl-1-penten, 1-Hexen, 1-Hepten, 1-Octen, 1-Decen, 1-Undecen, 1-Dodecen, 1-Tetradecen, 1-Hexadecen und 1-Eicosen.

8. Einkapselungsfilmzusammensetzung gemäß Anspruch 1, worin das Alpha-Olefin in einer Menge von mehr als 0 und weniger als oder gleich zu 99 mol-% enthalten ist, bezogen auf das Ethylen/Alpha-Olefin-Copolymer.

9. Einkapselungsfilmzusammensetzung gemäß Anspruch 1, ferner umfassend zumindest eines, das ausgewählt ist aus der Gruppe bestehend aus einer ungesättigten Silanverbindung, einer Aminosilanverbindung, einem Lichtstabilisator, einem UV-Absorber und einem thermischen Stabilisator.

10. Einkapselungsfilm, umfassend die Einkapselungsfilmzusammensetzung gemäß irgendeinem der Ansprüche 1 bis 9.

11. Solarzellenmodul, umfassend den Einkapselungsfilm gemäß Anspruch 10.

## Revendications

1. Composition de film d'encapsulation comprenant un copolymère d'éthylène/alpha-oléfine, un agent de réticulation, un auxiliaire de réticulation, et un peroxyde organique, dans laquelle l'auxiliaire de réticulation comprend un composé représenté par la Formule 1 ci-dessous : 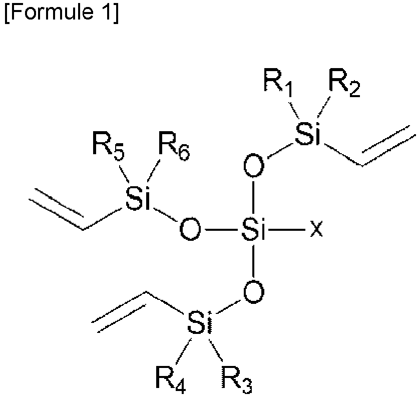 où, dans la Formule 1 ci-dessus,
R₁ à R₆ sont chacun indépendamment un groupe alkyle présentant 1 à 10 atomes de carbone, et
X est un groupe aryle présentant 6 à 30 atomes de carbone ou 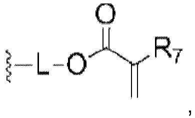
où L est un groupe alkylène présentant 1 à 10 atomes de carbone, et R₇ est un groupe alkyle présentant 1 à 10 atomes de carbone.

2. Composition de film d'encapsulation selon la revendication 1, dans laquelle, dans la Formule 1 ci-dessus, R₁ à R₆ sont chacun indépendamment un groupe alkyle présentant 1 à 6 atomes de carbone.

3. Composition de film d'encapsulation selon la revendication 1, dans laquelle le composé représenté par la Formule 1 ci-dessus est sélectionné parmi les composés ci-dessous :

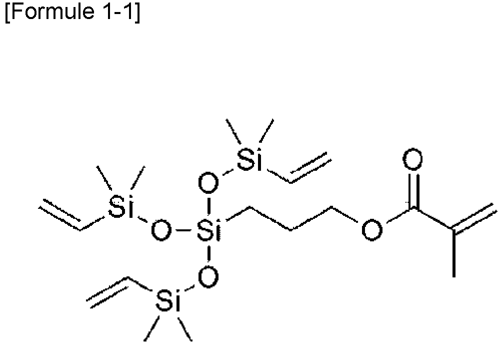

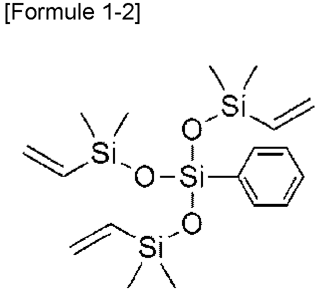

4. Composition de film d'encapsulation selon la revendication 1, dans laquelle l'auxiliaire de réticulation est contenu dans une quantité de 0,01 partie en poids à 1 partie en poids sur la base de 100 parties en poids de la composition de film d'encapsulation.

5. Composition de film d'encapsulation selon la revendication 1, comprenant en outre un composé contenant un groupe allyle en tant que l'auxiliaire de réticulation,
dans laquelle le composé contenant un groupe allyle comprend au moins un sélectionné dans le groupe consistant en isocyanurate de triallyle, cyanurate de triallyle, phtalate de diallyle, fumarate de diallyle, et maléate de diallyle.

6. Composition de film d'encapsulation selon la revendication 5, dans laquelle le rapport molaire du composé représenté par la Formule 1 ci-dessus et du composé contenant un groupe allyle est 1:0,1 à 1:10.

7. Composition de film d'encapsulation selon la revendication 1, dans laquelle l'alpha-oléfine comprend au moins un sélectionné dans le groupe consistant en propylène, 1-butène, 1-pentène, 4-méthyl-1-pentène, 1-hexène, 1-heptène, 1-octène, 1-décène, 1-undécène, 1-dodécène, 1-tétradécène, 1-hexadécène, et 1-eicosène.

8. Composition de film d'encapsulation selon la revendication 1, dans laquelle l'alpha-oléfine est contenue dans une quantité supérieure à 0 et inférieure ou égale à 99 %mol, sur la base du copolymère d'éthylène/alpha-oléfine.

9. Composition de film d'encapsulation selon la revendication 1, comprenant en outre au moins un sélectionné dans le groupe consistant en un composé silane non saturé, un composé aminosilane, un photostabilisant, un absorbeur UV, et un stabilisant thermique.

10. Film d'encapsulation comprenant la composition de film d'encapsulation selon l'une quelconque des revendications 1 à 9.

11. Module de cellule solaire comprenant le film d'encapsulation selon la revendication 10.
